Europäisches Patentamt

**European Patent Office**

**Office européen des brevets**

(19)

(11) Numéro de publication: **0 048 514**
**B1**

(12) **FASCICULE DE BREVET EUROPEEN**

(45) Date de publication du fascicule du brevet: **18.07.84**

(21) Numéro de dépôt: **81201013.0**

(22) Date de dépôt: **11.09.81**

(51) Int. Cl.³: **C 30 B 1/08, C 30 B 29/02,**
**C 30 B 29/40,**
**C 30 B 29/48, G 02 B 5/16,**
**B 23 K 26/00**

(54) **Procédé de cristallisation de films et films ainsi obtenus.**

(30) Priorité: **18.09.80 LU 82779**
**10.08.81 LU 83540**

(43) Date de publication de la demande:
**31.03.82 Bulletin 82/13**

(45) Mention de la délivrance du brevet:
**18.07.84 Bulletin 84/29**

(84) Etats contractants désignés:
**AT BE CH DE FR GB IT LI NL SE**

(56) Documents cités:
**GB - A - 1 485 695**
**GB - A - 2 001 780**
**GB - A - 2 037 000**
**US - A - 3 843 865**
**US - A - 4 059 461**
**US - A - 4 187 126**

**APPLIED PHYSICS LETTERS, vol. 35, no. 5, 1er**
**septembre 1979 R. ANDREW et al.: "Laser**
**induced metal to semiconductor phase transition**
**in mixed Al-Sb films", pages 418-420**
**JOURNAL OF PHYSICS E. SCIENTIFIC**
**INSTRUMENTS, vol. 12, aoÛt 1979, no. 8 A.G.**
**CULLIS et al.: "A device for laser beam diffusion**
**and homogenisation", pages 688-689**

(73) Titulaire: **L'Etat belge, représenté par le Secrétaire**
**Général des Services de la Programmation de la**
**Politique Scientifique**
**8 rue de la Science**
**B-1040 Bruxelles (BE)**

(72) Inventeur: **Laude, Lucien Diego**
**Rue des Lilas, 64**
**Hautmont (FR)**

(74) Mandataire: **Pirson, Jean et al,**
**c/o Bureau Gevers, S.A. rue de Livourne, 7 bte 1**
**B-1050 Brussels (BE)**

(56) Documents cités:
**JOURNAL OF APPLIED PHYSICS, vol. 51, mai**
**1980, no. 5, American Institute of Physics, New**
**York, US S. MATTESON et al.: "Epitaxial**
**regrowth of Ar implanted amorphous Si by laser**
**annealing", pages 2625-2629**
**REVUE DE PHYSIQUE APPLIQUEE, vol. 15, mars**
**1980 J.C. MULLER et al: "Emploi de lasers dans**
**la technologie des photopiles", pages 611-629**
**APPLIED PHYSICS LETTERS, vol. 33 1 aoÛt**
**1978 American Institute of Physics, J.C. BEAN**
**et al.: "Epitaxial laser crystallization of thin-film**
**amorphous silicon", pages 227-229**

Courier Press, Leamington Spa, England.

## Description

La présente invention est relative à un procédé de cristallisation de films choisis dans le groupe comprenant les films semi-conducteurs élémentaires amorphes et les films polymétalliques composés de deux éléments appartenant respectivement aux Groupes III et V ou aux Groupes II et VI du Tableau Périodique, ainsi qu'aux films polycristallins semi-conducteurs ainsi obtenus.

La miniaturisation des circuits électroniques est l'un des objectifs majeurs de l'industrie électronique et informatique. Les techniques actuelles font appel à des procédés de dopage sélectif de plaquettes de silicium monocristallin par des masquages variés dont la précision détermine les limites de développement de ces circuits. Ces procédés sont onéreux, très délicats à mettre en place et seuls quelques systèmes ont pu être développés qui soient fiables et de grande capacité. Ces systèmes sont réalisés à partir de silicium monocristallin, ce qui implique la nécessité de disposer de ce matériau en qualité et en quantité suffisantes pour produire les circuits. Tous les procédés se décomposent en plusieurs étapes, chacune d'elles étant caractérisée par un nombre important de paramètres qui doivent être contrôlés avec précision: préparation du cristal, masquage, dopage. Ces paramètres rendent la réalisation des circuits miniaturisés une entreprise très complexe qui ne saurait être généralisable à d'autres matériaux de base que le silicium, par exemple, sans une modification générale de tous les paramètres. Le manque de flexibilité de ces techniques et leur complexité soulignent le besoin d'une technique nouvelle plus simple et facilement adaptable à d'autres supports que le Si monocristallin.

La présente invention a pour but de remédier aux inconvénients susmentionnés, et de prévoir des procédés de cristallisation de films semi-conducteurs élémentaires amorphes ou de films polymétalliques composés de deux éléments appartenant respectivement aux Groupes III et V ou aux Groupes II et VI du Tableau Périodique, qui présentent une fiabilité au moins identique aux méthodes utilisées jusqu'à présent, et qui permettent en outre une miniaturisation plus avancée et une multiplication simultanée à grande échelle des produits obtenus.

A cet effet, suivant l'invention, on irradie la surface du film à cristalliser par un faisceau laser guidé par un assemblage de fibres optiques disposées parallèlement les unes aux autres, chaque fibre ayant un diamètre n'excédant pas 50 $\mu$m, l'irradiation provoquant la cristallisation en cristallites régulièrement répartis et étroitement confinés.

Suivant une forme de réalisation particulièrement avantageuse de l'invention, les fibres optiques ont un diamètre égal à 50 $\mu$m et de préférence un diamètre compris entre 4 et 25 $\mu$m, l'assemblage de fibres optiques parallèles ayant un diamètre sensiblement égal à celui du faisceau laser, cet assemblage de fibres comprenant un nombre très important de fibres, de préférence compris entre 300 et 15000 fibres, le nombre de fibres variant suivant le diamètre utile de ces fibres et le diamètre utile du faisceau du laser.

Suivant une autre forme de réalisation particulière du procédé de l'invention, le faisceau laser est homogénéisé avant d'être guidé par l'assemblage de fibres, par passage au travers d'un barreau cylindrique de quartz de diamètre d'entrée sensiblement égal au diamètre du faisceau laser, coudé deux fois à angle droit en directions opposées, recouvert d'une couche métallique, les extrémités d'entrée et de sortie du barreau étant polies, parallèles entre elles et perpendiculaires à son axe.

Avantageusement, on obtient un réseau ou circuit ordonné de cristallites sur le film que l'on irradie, en déplaçant celui-ci dans un plan perpendiculaire à l'axe des fibres, la finesse d'impression du réseau ou circuit de cristallites étant contrôlée par la vitesse de déplacement du film.

La présente invention a également pour but la réalisation d'un procédé permettant de multiplier l'impression d'un réseau ou circuit ordonné de cristallites sur un seul film ou sur un assemblage de films semi-conducteurs élémentaires ou polymétalliques entrant dans la catégorie des films susmentionnés.

Les buts dont il est question ci-dessus, sont atteints en utilisant le rayonnement produit par un laser dont l'énergie et la séquence de fonctionnement (pulsé ou continu) sont adaptés à l'épaisseur du film à traiter. L'énergie du faisceau laser est prélevée par un assemblage de fibres optiques d'un diamètre inférieur ou égal à 50 $\mu$m, de préférence compris entre 4 et 25 $\mu$m, et dirigée vers une cible constituée d'un film semiconducteur élémentaire amorphe ou d'un film polymétallique composé de deux éléments appartenant respectivement aux Groupes III et V et aux Groupes II et VI du Tableau Périodique. Sous l'impact du faisceau, le film élémentaire amorphe cristallise de façon ordonnée et confinée à des volumes très réduits déterminés par le diamètre des fibres et la distance entre l'extrémité de sortie de la fibre et la cible. Sur des volumes identiques, le film polymétallique cristallise sous la forme du composé semi-conducteur correspondant, le reste du film (non irradié) demeurant métallique. Par un déplacement programmé de cette cible dans un plan perpendiculaire à l'axe des fibres, un réseau ordonné de cristallites est alors "imprimé" optiquement sur le film dont les propriétés de transport électronique (mobilité et nombre des porteurs) se trouvent ainsi fortement modifiées de plusieurs ordres de grandeur en zones irradiées par rapport aux zones non irradiées. L'utilisation d'un très grand nombre N de fibres identiques transmettant chacune la même énergie permet alors de reproduire N fois le circuit programmé, et de réaliser l'interconnection éventuellement désirée de ces N circuits. Des cibles qui se sont révélées comme étant particulièrement appropriées à cet effet, sont les films semi-conducteurs formés de Si ou de Ge, et les films polymétalliques composés d'une alternance de couches d'aluminium et d'antimoine, d'aluminium et d'arsenic, de galium et d'arsenic, d'indium et de phosphore (Groupes III et V), ou de cadmium et de soufre, de cadmium et de tellure (Groupes II et VI).

D'autres détails et particularités de l'invention ressortiront de la description donnée ci-après à titre d'exemple non limitatif de quelques formes particulières de l'invention.

La description donnée ci-après concernera particulièrement la mise en forme du faisceau laser, le balayage des surfaces irradiées par le déplacement du ou des films irradiés et la reproduction simultanée en un grand nombre d'exemplaires d'un réseau ou circuit ordonné de cristallites sur un seul film (cible) ou un assemblage de films (cibles différentes).

1. Mise en forme du faisceau.

Suivant l'épaisseur des films à traiter qui peut aller jusqu'à 25 $\mu$m, le rayonnement laser peut avoir différentes origines, par exemple: laser pulsé à colorant de moyenne puissance et faible énergie (50 à 100 mJ/cm²) pour des films minces d'épaisseur inférieure ou égale à 0,2 $\mu$m sur verre, ou laser pulsé à rubis de grande puissance mais faible énergie (50 à 100 mJ/cm²) pour des films d'épaisseur de l'ordre de 1 à 2 $\mu$m, déposés également sur substrat non cristallin, par exemple du verre ou de la silice fondue, ou laser continu à gaz de grande énergie (1 à 5 J/cm²) pour des films d'épaisseur supérieure à 2 $\mu$m pouvant atteindre 25 $\mu$, et déposés aussi sur ces mêmes substrats. Quel que soit le faisceau laser, celui-ci est mis en regard d'un assemblage de fibres de quartz parallèles, identiques, d'un diamètre inférieur ou égal à 50 $\mu$m, assemblées sur un diamètre égal à celui du faisceau, le faisceau laser pénétrant toutes les fibres suivant leur axe longitudinal respectif. Les fibres, par exemple au nombre de 1000 à 2000, ont toutes un diamètre égal, le nombre des fibres étant uniquement limité par le diamètre utile du faisceau sur lequel celui-ci est homogène et par le diamètre des fibres. Chaque fibre est polie à ses extrémités. Ce travail est réalisé en assemblant toutes les fibres de manière compacte, maintenues à chaque extrémité par une bague métallique d'un diamètre inférieur ou égal au diamètre utile du faisceau. Ainsi montées, toutes les fibres sont polies ensemble, à leurs deux extrémités successives, par abrasif sur table tournante. Les extrémités respectives des fibres assemblées sont toutes situées dans un même plan disposé perpendiculairement à l'axe longitudinal de chacune de ces fibres. Les extrémités des fibres tournées vers le faisceau laser sont alors maintenues dans leur bague d'assemblage, les extrémités opposées étant libérées de leur bague.

Ainsi qu'on l'a déjà précisé, suivant une forme de réalisation préférée de l'invention, avant d'être guidé par l'assemblage de fibres, le faisceau laser peut être rendu homogène par passage au travers de tout moyen optique adéquat connu de l'état de la technique. L'homogénéiseur utilisé est de préférence un barreau cylindrique de quartz, de diamètre d'entrée égal au diamètre du faisceau laser, coudé deux fois à angle droit en directions opposées, recouvert d'une couche métallique, par exemple d'un film d'aluminium, les extrémités d'entrée et de sortie du barreau étant polies, parallèles entre elles et perpendiculaires à son axe. Le faisceau laser peut éventuellement être concentré par un système de lentilles à l'entrée du barreau. Lorsque l'on utilise un barreau homogénéiseur de ce type, les extrémités des fibres tournées vers le faisceau homogénéisé sont maintenues dans leur bague d'assemblage, qui est alors amenée au contact de la sortie du barreau, les extrémités opposées étant bien entendu libérées de leur bague, ainsi qu'on vient de la mentionner.

Etant donné que toutes les fibres sont identiques et reçoivent chacune la même énergie (à plus ou moins 1%), la capacité de chaque fibre de transmettre le rayonnement sans pertes (soit par absorption, soit par transmission (latérale) permet alors de disposer d'un très grand nombre de sources de lumière d'énergie identique, sur des diamètres identiques. Suivant l'énergie nécessaire, le rayonnement laser peut être réduit par un ou plusieurs filtres calibrés disposés sur le trajet du faisceau, perpendiculairement à celui-ci, avant l'entrée des fibres. Après avoir traversé l'assemblage de fibres optiques, le faisceau laser peut être structuré, par exemple par passage au travers d'un moyen optique agencé pour produire des franges d'interférence, ce moyen optique pouvant être constitué soit par un réseau optique en quartz gravé, soit par une lentille de Fresnel. La structuration du faisceau peut aussi être réalisée en faisant passer celui-ci au travers d'une grille métallique de maille régulière et très fine (20×20 $\mu$m par exemple) disposée perpendiculairement à l'axe des fibres.

2. Cristillisation et balayage des films.

Si le réseau n'est pas utilisé, le faisceau qui sort de l'extrémité d'une fibre présente une structure granulaire (ou "speckle"), c'est-à-dire que son impact sur une surface se décompose en un ensemble de tâches sensiblement circulaires réparties de façon homogène et stable d'une irradiation à l'autre. La taille de ces "grains" de lumière est donnée par

$$\Delta = \frac{\lambda}{\mathrm{tg}\,\alpha},$$

où $\lambda$ est la longueur d'onde du rayonnement et $\alpha$ l'angle sous lequel chaque site de la cible constituée par le film voit le rayon R de la fibre. Si

$$tg\alpha = \frac{R}{d} \rightarrow \Delta = \frac{\lambda}{R} d,$$

où d est la distance entre cible et fibre.

On voit que pour une fibre donnée et une longueur d'onde fixée, $\Delta$ croît avec d. Par contre $\Delta$ diminue si R augmente, à d constant. Une irradiation de ce type produit des cristallites étoilés an nombre et dimension identiques à ceux des tâches du speckle, couvrant toute la surface irradiée dont le diamètre est égal à celui de la fibre. En agissant sur le speckle (donc sur $\Delta$, R et d), il est par la suite aisé de faire varier la taille des cristallites, en particulier de produire un seul cristallite étoilé de diamètre égal à celui de la fibre.

En interposant sur le parcours du faisceau un réseau optique, chaque tâche du speckle est frangée et les étoiles produites sont structurées.

En régime pulsé, etant donné qu'aucune altération des zones cristallisées produites sur une pulsation n'est observée quand on superpose un train de pulsations sur ces mêmes zones, on déplace la surface du film à irradier en regard d'une extrémité de fibre fixe, c'est-à-dire dans un plan perpendiculaire à l'axe de cette fibre, de façon à permettre un recouvrement des zones irradiées d'une pulsation à la suivante, permettant d'obtenir ainsi un réseau ou circuit ordonné de cristallites. Ce recouvrement détermine la finesse de l'impression du circuit cristallisé dans le film, finesse que l'on contrôle en faisant varier d'une part la vitesse de déplacement du film, c'est-à-dire en fait la vitesse de balayage de la surface du film au moyen du rayonnement laser transmis par les fibres optiques, et d'autre part le taux de répétition des pulsations du laser.

En régime continu, la croissance cristalline produite sous l'effet du laser étant en tout état de cause beaucoup plus rapide que les vitesses pratiques de balayage et compte tenu de ce qui a été dit plus haut, il n'y a pas de précaution particulière à prendre et le balayage en régime laser continu peut être notablement plus rapide qu'en régime pulsé.

3. Procédé permettant la multiplication de l'impression d'un réseau ou circuit ordonné de cristallites.

Ainsi qu'on l'a déjà mentionné ci-dessus, la présente invention prévoit également un procédé permettant de multiplier l'impression d'un réseau ou circuit ordonné de cristallites sur un seul film, ou sur un assemblage de films, choisis dans le groupe comprenant les films semi-conducteurs élémentaires amorphes et les films polymétalliques composés de deux éléments appartenant respectivement aux Groupes III et V ou aux Groupes II et VI du Tableau Périodique. Les extrémités de sortie des fibres montées dans l'axe du faisceau mis en forme tel que décrit précédemment, sont assemblées sur un châssis-plan suivant une configuration géométrique adaptée au nombre de fibres et à l'étendue du réseau ou circuit de cristallites à imprimer. L'assemblage sur le châssis est tel que toutes les fibres sont parallèles entre elles et leurs extrémités dans un même plan parallèle au plan du châssis. En regard de ce châssis et parallèlement à celui-ci, on monte un autre châssis-plan sur lequel est monté soit le film à irradier, couvrant toute la surface de ce châssis, soit l'assemblage des films à irradier, distribués suivant une configuration géométrique identique à celle du montage des fibres sur leur châssis, de manière à accomoder l'étendue du réseau ou circuit de cristallites à réaliser en un nombre d'exemplaires égal au nombre de fibres (chaque fibre se trouvant en regard direct d'un film donné). La distance entre les châssis supportant le ou les films, constituant la cible, et celui des fibres est ajustée de façon à ce que la distance entre fibre et film corresponde à l'impression désirée (se référer, à ce sujet, au chapitre 2 précédent). Le châssis supportant le ou les films peut se déplacer dans son plan, à distance fixe du précédent. Un mouvement de translation est alors procuré au châssis-film. Ce mouvement permet à chaque fibre d'imprimer optiquement un circuit ou réseau ordonné de cristallites semi-conducteurs sur le film unique ou sur chaque film monté sur le châssis.

On peut également, suivant l'invention, réaliser l'interconnection de réseaux ou circuits ordonnés de cristallites obtenus sur un même film polymétallique composé de deux éléments appartenant respectivement aux Groupes III et V ou aux Groupes II et VI du Tableau Périodique, en utilisant le même ensemble de fibres que celui utilisé pour la réalisation des réseaux ou circuits, et en déplaçant le châssis-film de telle façon que l'impact du faisceau laser canalisé par les fibres impriment les contacts semi-conducteurs désirés entre chaque réseau ou circuit et ses voisins immédiats (premiers voisins) sur le film.

On constatera, compte tenu de ce que précède, que la dimension et la répartition des cristallites sur le ou les films à irradier, quel que soit le processus de cristallisation utilisé, sont contrôlables en fonction du diamètre des fibres optiques, de la distance fibre-film, ainsi que de la longueur d'onde, de l'énergie et de la puissance du faisceau laser irradiant le film.

La mise en forme du faisceau laser étant stable dans l'espace, il est possible d'irradier successivement dans les mêmes conditions d'énergie, deux films superposés, permettant une cristallisation épitaxique du second film recouvrant le premier, c'est-à-dire une superposition exacte des cristallites appartenant à chacun de ces films. Un tel exemple de films superposés est donné par le système Si/Al-Sb,

obtenu an évaporant une couche amorphe de Si sur un film Al-Sb, cristallisé au préalable suivant l'invention, sous la forme du composé semi-conducteur AlSb, le film de Si étant irradié par le même faisceau laser et de façon identique.

Les exemples qui suivent illustrent l'invention sans toutefois la limiter.

Exemple 1
Film de germanium.

Les expériences et essais décrits ci-après ont été réalisés avec des fibres optiques d'un diamètre égal à 50 μm, les résultats obtenus étant évidemment extrapolables à n'importe quel diamètre de fibre d'un diamètre inférieur à 50 μm,

Pour le laser pulsé (à colorant, puissance de 6 KW pour des pulsations de $10^{-6}$ s répétés à un taux de 25 $s^{-1}$), les résultats suivants ont été enregistrés:

— un faisceau homogène de 2 mm de diamètre utile a été produit, pouvant accomoder 300 fibres d'un diamètre utile de 50 μm;
— sur les zones du film de germanium irradiées, d'un diamètre de 50 μm, on a obtenu une distribution homogène de cristallites étoilés, tous d'un même diamètre choisi dans la gamme de 2 à 25 μ suivant les conditions d'irradiation, cette distribution homogène étant reproductible. Une étoile unique d'un diamètre de 50 μm a été obtenue en plaçant le film cible à 2 mm de l'extrémité de la fibre et en concentrant légèrement le faisceau, l'énergie par unité de surface étant alors réduite;
— avec un recouvrement de 90% entre zones irradiées successives, le déplacement du film cible à une vitesse de 0,12 mm $s^{-1}$ permet une définition des limites de l'impression à ±0,3%, soit 0,13 μm, telle que de très grands cristallites (longueur de 100 μm en moyenne, pouvant atteindre 200 μm) de type dendritique sont créés suivant la direction du balayage dans la trace (largeur 50 μm) qui est bordée par une zone de quelques microns de profondeur constituée de petits cristallites (~0,5 μm).

Exemple 2
Film der germanium.

Pour des fibres de μm de diamètre utile, la miniaturisation des zones cristallisées est la suivante:

— un seul cristallite par impact de dimension égale à 7 μm pour une distance d film-fibre égale à 40 μm;
— pour un recouvrement de 90% entre zones irradiées successives, une vitesse de déplacement de 0,017 mm $s^{-1}$ permet une définition des bords de ±,25%, soit 0,017 μm.

On notera que les avantages des fibres d'un très faible diamètre sur les fibres de diamètre de 50 μm résident dans une meilleure définition des tracés, dans une réduction de l'intensité nécessaire du rayonnement à sa source, dans une vitesse de balayage plus grande, et dans une multiplication bien plus importante des circuits réalisés (d l'ordre de 15000, au lieu de 300 avec des fibres de 50 μm).

Exemple 3
Film de AlSb.

Pour un laser continu à gaz (krypton, énergie de 3 J/cm²), l'irradiation par balayage du faisceau canalisé par une fibre de diamètre de 50 μm ou 7 μm sur un film polymétallique Al-Sb d'épaisseur égale à 7 μm produit la transformation en le composé semi-conducteur AlSb le long du parcours de la tâche de lumière sur le film, le reste du film restant métallique.

Il est bien etendu que l'invention n'est pas limitée aux formes de réalisation décrites.

C'est ainsi que comme substrats pour déposer les films, on utilise de préférence des substrats non cristallins ou amorphes, tels que plaques de verre ou de silice fondue, nettoyés par bombardement ionique d'un gaz neutre, tel que, par exemple, de l'argon, pendant une durée de l'ordre de quelques minutes, par exemple de 1 à 5 minutes.

**Revendications**

1. Procédé de cristallisation d'un film choisi dans le groupe comprenant les films semi-conducteurs élémentaires amorphes et les films polymétalliques composés de deux éléments appartenant respectivement aux Groupes III et V ou aux Groupes II et VI du Tableau Périodique, caractérisé en ce qu'il consiste à irradier la surface du film par un faisceau laser guidé par un assemblage de fibres optiques disposées parallèlement les unes aux autres, chaque fibre ayant un diamètre n'excédant pas 50 μm, de façon à ce que l'irradiation provoque la cristallisation en cristallites régulièrement répartis et étroitement confinés.

2. Procédé suivant la revendication 1, caractérisé en ce que les fibres optiques ont un diamètre égal à 50 μm.

3. Procédé suivant l'une ou l'autre des revendications 1 et 2, caractérisé en ce que le film est déposé sur un substrat non cristallin.

4. Procédé suivant la revendication 1, caractérisé en ce que les fibres optiques ont un diamètre compris entre 4 et 25 μm.

5. Procédé suivant l'une quelconque des revendications 1 à 4, caractérisé en ce que les fibres optiques ont chacune un diamètre égal.

6. Procédé suivant l'une quelconque des revendications 1 à 5, caractérisé en ce que l'on utilise comme fibres optiques, des fibres de quartz identiques.

7. Procédé suivant l'une quelconque des revendications 1 à 6, caractérisé en ce que l'assemblage de fibres optiques parallèles a un diamètre sensiblement égal à celui du faisceau laser.

8. Procédé suivant la revendication 7, caractérisé en ce que l'assemblage de fibres comprend de 300 à 15000 fibres.

9. Procédé suivant l'une quelconque des revendications 1 à 8, caractérisé en ce que le faisceau laser est mis en regard des fibres optiques assemblées de manière à pénétrer celles-ci suivant leur axe longitudinal.

10. Procédé suivant l'une quelconque des revendications 1 à 9, caractérisé en ce que les fibres optiques sont assemblées de manière compacte, polies à chacune de leurs extrémités et maintenues par leur extrémité orientée vers le faisceau au moyen d'une bague métallique d'un diamètre n'excédant pas le diamètre utile du faisceau laser.

11. Procédé suivant la revendication 10, caractérisé en ce que les extrémités respectives des fibres assemblées sont situées dans un même plan disposé sensiblement perpendiculairement à l'axe longitudinal de ces fibres.

12. Procédé suivant l'une quelconque des revendications 1 à 11, caractérisé en ce que le faisceau laser est homogénéisé avant d'être guidé par l'assemblage de fibres.

13. Procédé suivant la revendication 12, caractérisé en ce que le faisceau laser est homogénéisé par passage au travers d'un barreau cylindrique de quartz d'un diamètre d'entrée sensiblement égal au diamètre du faisceau laser, coudé deux fois à angle droit en directions opposées, recouvert d'une couche métallique, les extrémités d'entrée et de sortie du barreau étant polies, parallèles entre elles et perpendiculaires à son axe.

14. Procédé suivant la revendication 13, caractérisé en ce que le faisceau laser est concentré par un système de lentilles avant d'être homogénéisé.

15. Procédé suivant l'une quelconque des revendications 1 à 14, caractérisé en ce que le rayonnement du faisceau laser est réduit par un ou plusieurs filtres disposés sur le trajet du faisceau, perpendiculairement à celui-ci, avant son entrée dans l'assemblage de fibres optiques.

16. Procédé suivant l'une quelconque des revendications 1 à 15, caractérisé en ce que le faisceau laser est structuré après avoir traversé l'assemblage de fibres optiques.

17. Procédé suivant la revendication 16, caractérisé en ce que le faisceau laser est structucé par passage au travers d'un moyen optique pour produire des franges d'interférence.

18. Procédé suivant la revendication 17, caractérisé en ce que le moyen optique agencé pour produire des franges d'interférence est constitué par un réseau optique en quartz gravé.

19. Procédé suivant la revendication 17, caractérisé en ce que le moyen optique agencé pour produire des franges d'interférence est constitué par une lentille de Fresnel.

20. Procédé suivant la revendication 17, caractérisé en ce que le moyen optique agencé pour produire des franges d'interférence est constitué par une grille métallique de maille régulière et très fine disposée perpendiculairement à l'axe des fibres.

21. Procédé suivant l'une quelconque des revendications 1 à 20, caractérisé en ce que le substrat non cristallin est nettoyé par bombardement ionique d'un gaz neutre, tel que l'argon.

22. Procédé suivant l'une quelconque des revendications 1 à 21, caractérisé en ce que le faisceau laser irradiant le film est en régime pulsé et d'énergie comprise entre 50 et 100 $mJ/cm^2$.

23. Procédé suivant l'une quelconque des revendications 1 à 21, caractérisé en ce que le faisceau laser irradiant le film est en régime continu et d'énergie comprise entre 1 et 5 $J/cm^2$.

24. Procédé suivant l'une quelconque des revendications 1 à 22, caractérisé en ce que l'épaisseur du film est inférieure ou égale à 0,2 $\mu$m et en ce que le faisceau laser est un faisceau laser pulsé à colorant.

25. Procédé suivant l'une quelconque des revendications 1 à 22, caractérisé en ce que lépaisseur du film est comprise entre 1 et 2 $\mu$m et en ce que le faisceau laser est un faisceau laser pulsé à rubis.

26. Procédé suivant l'une quelconque des revendications 1 à 21 et 23, caractérisé en ce que l'épaisseur du film est comprise entre 2 et 25 $\mu$m et en ce que le faisceau laser est un faisceau laser continu à gaz.

27. Procédé suivant l'une quelconque des revendications 1 à 26, caractérisé en ce que l'on contrôle la dimension et la répartition des cristallites sur le film en fonction du diamètre des fibres optiques, de la distance fibre-film ainsi que de la longueur d'onde, de l'énergie et de la puissance du faisceau laser irradiant le film.

28. Procédé suivant la revendication 27, caractérisé en ce que la distance fibre-film est de l'ordre de 0,5 à 5 mm.

29. Procédé suivant l'une quelconque des revendications 1 à 28, caractérisé en ce que l'on déplace le film dans un plan perpendiculaire à l'axe des fibres de manière à obtenir un réseau ou circuit ordonné de cristallites.

30. Procédé suivant la revendication 29, caractérisé en ce que l'on contrôle la finesse d'impression du réseau ou circuit de cristallites par la vitesse de déplacement du film et le taux de répétition des pulsations du laser.

31. Procédé suivant l'une quelconque des revendications 1 à 30, caractérisé en ce que l'on utilise un film semi-conducteur amorphe formé de silicium ou de germanium.

32. Procédé suivant l'une quelconque des revendications 1 à 30, caractérisé en ce que l'on utilise un film polymétallique composé d'une alternance de couches d'aluminium et d'antimoine, d'aluminium et d'arsenic, de galium et d'arsenic, d'indium et de phosphore (Groupes III et V), de cadmium et de soufre, ou de cadmium et de tellure (Groupes II et VI).

33. Procédé permettant de multiplier l'impression d'un réseau ou circuit ordonné de cristallites sur un seul film ou sur un assemblage de films choisis dans le groupe comprenant les films semi-conducteurs élémentaires amorphes et les films polymétalliques composés de deux éléments appartenant respectivement aux Groupes III et V ou aux Groupes II et VI du Tableau Périodique, caractérisé en ce qu'il consiste à irradier la surface du ou des films semi-conducteurs par un faisceau laser guidé par l'assemblage de fibres optiques suivant l'une quelconque des revendications 1 à 28, en assemblant les extrémités de sortie des fibres montées dans l'axe du faisceau sur un châssis-plan fixe suivant une configuration géométrique adaptée au nombre de fibres et à l'étendue du réseau ou circuit imprimé désiré, les fibres sur le châssis étant parallèles les unes aux autres et leurs extrémités étant disposées dans un même plan parallèle au plan du châssis, et en agençant parallèlement au châssis de fibres et en regard de celui-ci, un châssis-plan mobile sur lequel est monté le film précité, couvrant toute la surface du châssis, ou l'assemblage de films précités, distribués suivant une configuration géométrique identique à celle du montage de fibres sur leur châssis, chaque fibre faisant face à un film donné, et à déplacer le châssis supportant le film ou l'assemblage de films dans un mouvement de translation par rapport au châssis de fibres, le châssis-film restant à distance fixe du châssis-fibre, permettant ainsi à chaque fibre d'imprimer un réseau ou circuit ordonné de cristallites sur le film unique ou sur chaque film monté sur le châssis.

34. Procédé suivant la revendication 33, caractérisé en ce que l'on ajuste la distance entre les châssis film et fibre de façon à ce que la distance entre fibre et film corresponde à l'impression désirée.

35. Procédé selon la revendication 33 ou 34 permettant de réaliser l'interconnection de réseaux ou circuits ordonnés de cristallites obtenus sur un même film polymétallique composé de deux éléments appartenant respectivement aux Groupes III et V ou aux Groupes II et VI du Tableau Périodique, caractérisé en ce qu'il consiste à déplacer le châssis-film de telle façon que les impacts du faisceau laser canalisé par les fibres impriment les contacts semiconducteurs désirés entre chaque réseau ou circuit et ses voisins immédiats sur le film.

36. Procédé de cristallisation de deux films superposés choisis, d'une part, dans le groupe comprenant les films semi-conducteurs élémentaires amorphes et, d'autre part, les films polymétalliques composés de deux éléments appartenant respectivement aux Groupes III et V ou aux Groupes II et VI du Tableau Périodique, caractérisé en ce qu'il consiste à cristalliser un premier film suivant l'une quelconque des revendications 1 à 32, à lui superposer par évaporation un second film, et à irradier ce second film de la même manière que le premier de façon à obtenir une cristallisation épitaxique de ce second film sur le premier.

37. Procédé suivant la revendication 36, caractérisé en ce que le premier film est un film composé d'une alternance de couches d'aluminium et d'antimoine et en ce que le second film est formé de silicium.

## Patentansprüche

1. Verfahren zur Kristallisation einer filmartigen dünnen Schicht aus der die elementaren amorphen Halbleiterschichten und die aus zwei den Gruppen III bzw. V oder den Gruppen II bzw. VI des periodischen Systems angehörenden Elementen zusammengesetzten polymetallischen Schichten enthaltenden Gruppe, dadurch gekennzeichnet, daß die Oberfläche der Schicht durch einen Laserstrahl bestrahlt wird, der von einem Verband parallel zueinander angeordneter optischer Fasern geführt wird, wobei jede Faser einen Durchmesser von nicht mehr als 50 $\mu$m hat, so daß die Bestrahlung die Kristallisation in regelmäßig verteilten und eng begrenzten Kristalliten bewirkt.

2. Verfahren nach Anspruch 1, dadurch gekennzeichnet, daß der Durchmesser der optischen Fasern gleich 50 $\mu$m ist.

3. Verfahren nach Anspruch 1 und 2, dadurch gekennzeichnet, daß die filmartige dünne Schicht auf einem nichtkristallinen Substrat abgelagert wird.

4. Verfahren nach Anspruch 1, dadurch gekennzeichnet, daß die optischen Fasern einen zwischen 4 und 25 $\mu$m liegenden Durchmesser besitzen.

5. Verfahren nach einem der Ansprüche 1 bis 4, dadurch gekennzeichnet, daß die optischen Fasern jeweils gleichen Durchmesser besitzen.

6. Verfahren nach einem der Ansprüche 1 bis 5, dadurch gekennzeichnet, daß als optische Fasern identische Quarzfasern verwendet werden.

7. Verfahren nach einem der Ansprüche 1 bis 6, dadurch gekennzeichnet, daß der Verband der parallelen optischen Fasern einen Durchmesser besitzt, der annähernd dem des Laserstrahls entspricht.

8. Verfahren nach Anspruch 7, dadurch gekennzeichnet, daß der genannte Verband 300 bis 15.000 Fasern umfaßt.

9. Verfahren nach einem der Ansprüche 1 bis 8, dadurch gekennzeichnet, daß der Laserstrahl relativ zu den den Verband bildenden optischen Fasern so positioniert ist, daß er in Richtung ihrer Längsachse in sie eindringt.

10. Verfahren nach einem der Ansprüche 1 bis 9, dadurch gekennzeichnet, daß die optischen Fasern kompakt zusammengefaßt und an jedem ihrer Enden poliert sind und daß sie durch ihr mit Laserstrahl zugewandten Ende von einem Metallring gehalten sind, dessen Durchmesser den ausnutzbaren Durchmesser des Laserstrahls nicht übersteigt.

11. Verfahren nach Anspruch 10, dadurch gekennzeichnet, daß die betreffenden Enden der zusammengefaßten Fasern in ein und derselben Ebene liegen, die annähernd senkrecht zur Längsachse dieser Fasern verläuft.

12. Verfahren nach einem der Ansprüche 1 bis 11, dadurch gekennzeichnet, daß der Laserstrahl homogenisiert wird, bevor er durch den Faserverband geleitet wird.

13. Verfahren nach Anspruch 12, dadurch gekennzeichnet, daß der Laserstrahl mittels Durchgang durch einen zylindrischen Quarzstab homogenisiert wird, dessen Eingangsdurchmesser annähernd gleich dem Durchmesser des Laserstrahls ist und der zweimal rechtwinklig in entgegengesetzten Richtungen abgewinkelt ist, daß der Stab mit einem metallischen Belag versehen ist, und daß seine eingangs- und ausgangsseitigen Enden poliert sind und parallel zueinander und senkrecht zu seiner Achse gerichtet sind.

14. Verfahren nach Anspruch 13, dadurch gekennzeichnet, daß der Laserstrahl durch ein Linsensystem konzentriert wird, bevor er homogenisiert wird.

15. Verfahren nach einem der Ansprüche 1 bis 14, dadurch gekennzeichnet, daß die Strahlung des Laserstrahls durch ein oder mehrere in seinem Strahlengang senkrecht zu ihm angeordnete Filterr reduziert wird, bevor er in den Verband der optischen Fasern eintritt.

16. Verfahren nach einem der Ansprüche 1 bis 15, dadurch gekennzeichnet, daß der Laserstrahl nach seinem Durchtritt durch den Verband der optischen Fasern strukturiert wird.

17. Verfahren nach Anspruch 16, dadurch gekennzeichnet, daß der Laserstrahl dadurch strukturiert wird, daß er durch ein optisches Mittel zur Erzeugung von Interferenzstreifen hindurchtritt.

18. Verfahren nach Anspruch 17, dadurch gekennzeichnet, daß das optische Mittel zur Erzeugung von Interferenzstreifen aus einem in Quarz geritzten optischen Raster besteht.

19. Verfahren nach Anspruch 17, dadurch gekennzeichnet, daß das optische Mittel zur Erzeugung von Interferenzstreifen aus einer Fresnel-Linse besteht.

20. Verfahren nach Anspruch 17, dadurch gekennzeichnet, daß das optische Mittel zur Erzeugung von Interferenzstreifen aus einem regelmäßigen und sehr feinmaschigen Metallgitter besteht, das senkrecht zur Achse der Fasern angeordnet ist.

21. Verfahren nach einem der Ansprüche 1 bis 20, dadurch gekennzeichnet, daß das nichtkristalline Substrat durch Ionenbeschuß eines neutralen Gases, z.B. Argon gereinigt wird.

22. Verfahren nach einem der Ansprüche 1 bis 21, dadurch gekennzeichnet, daß der die dünne Schicht bestrahlende Laserstrahl gepulst ist und eine im Bereich zwischen 50 und 100 $\mu$m/cm² liegende Energie aufweist.

23. Verfahren nach einem der Ansprüche 1 bis 21, dadurch gekennzeichnet, daß der die dünne Schicht bestrahlende Laserstrahl kontinuierlich mit einer im Bereich zwischen 1 und 5 mJ/cm² liegenden Energie betrieben wird.

24. Verfahren nach einem der Ansprüche 1 bis 22, dadurch gekennzeichnet, daß die Dicke der Schicht 0.2 $\mu$m oder weniger beträgt und daß der Laserstrahl ein gepulster Farbstofflasterstrahl ist.

25. Verfahren nach einem der Ansprüche 1 bis 22, dadurch gekennzeichnet, daß die Dicke der Schicht zwischen 1 und 2 $\mu$m liegt und daß der Laserstrahl ein gepulster Robinlaserstrahl ist.

26. Verfahren nach einem der Ansprüche 1 bis 21 und 23, dadurch gekennzeichnet, daß die Dicke der Schicht zwischen 2 und 25 $\mu$m liegt und daß der Laserstrahl ein kontinuierlicher Gaslasterstrahl ist.

27. Verfahren nach einem der Ansprüche 1 bis 26, dadurch gekennzeichnet, daß die Abmessung und Verteilung der Kristallite auf der Schicht in Abhängigkeit von dem Durchmesser der optischen Fasern, vom Abstand zwischen Faser und Schicht sowie von der Wellenlänge, der Energie und der Leistung des die Schicht bestrahlenden Laserstrahls gesteuert wird.

28. Verfahren nach Anspruch 27, dadurch gekennzeichnet, daß die Entfernung zwischen Faser und Schicht in der Größenordnung von 0,5 bis 5 mm liegt.

29. Verfahren nach einem der Ansprüche 1 bis 28, dadurch gekennzeichnet, faß die Schicht in einer senkrecht zur Achse der Fasern verlaufenden Ebene derart verschoben wird, daß man eine vorgeschriebene Netzanordnung oder Schaltung von Kristalliten erhält.

30. Verfahren nach Anspruch 29, dadurch gekennzeichnet, daß der Feinheitsgrad beim Drucken der vorgeschriebenen Netzanordnung oder Schaltung von Kristalliten durch die Verschiebungsgeschwindigkeit der Schicht und die Impulswiederholgeschwindigkeit des Lasers gesteuert wird.

31. Verfahren nach einem der Ansprüche 1 bis 30, dadurch gekennzeichnet, daß eine aus Silizium oder Germanium bestehende amorphe Halbleiterschicht verwendet wird.

32. Verfahren nach einem der Ansprüche 1 bis 30, dadurch gekennzeichnet, daß eine polymetallische Schicht verwendet wird, die aus einer abwechselnden Folge von Aluminium- und Antimonschichten, Galium- und Arsenikschichten, Indium- und Phosphorschichten (Gruppen III und V), Kadmium- und Schwefelschichten oder Kadmium- und Tellurschichten (Gruppen II und VI) zusammengesetzt ist.

33. Verfahren zur Vervielfachung des Druckes einer vorgeschriebenen Netzanordnung oder Schaltung von Kristalliten auf einer einzigen filmartigen Schicht oder einer Mehrfachanordnung solcher Schichten aus der die elementaren amorphen Halbleiterschichten und die aus zwei den Gruppen III bzw. V oder den Gruppen II bzw. VI des periodischen Systems angehörenden Elementen zusammengesetzten polymetallischen Schichten enthaltenden Gruppe, dadurch gekennzeichnet, daß die Oberfläche der Schicht oder Schichten mit einem durch den Verband der optischen Fasern geführten Laserstrahl nach einem der Ansprüche 1 bis 28 bestrahlt wird, daß die ausgangsseitigen Enden der in einer festen Rahmenfassung montierten Fasern in einer geommetrischen Konfiguration zusammengefaßt werden, die an die Zahl der Fasern und die Ausdehnung der gewünschten Netzanordnung oder gedrückten Schaltung angepaßt ist, wobei die Fasern an ihrer Rahmenfassung parallel zueinander und mit ihren Enden in ein und derselben parallel zur Ebene der Rahmenfassung verlaufenden Ebene angeordnet sind und wobei parallel zur Rahmenfassung der Fasern und ihr gegenüberliegend eine bewegliche Rahmenfassung angeordnet wird, auf der die genannte die ganze Oberfläche dieser Rahmenfassung bedeckende eine Schicht oder die genannte Mehrfachanordnung von Schichten montiert sind, wobei letztere in einer geometrischen Konfiguration verteilt sind, die mit derjenigen übereinstimmt, in der die Fasern an ihrer Rahmenfassung montiert sind, und jede Faser einer gegebenen Schicht zugewandt ist, und daß die die Schicht oder die Mehrfachanordnung von Schichten tragende Rahmenfassung in einer Translationsbewegung relativ zu der Rahmenfassung der Fasern verschoben wird, wobei die Rahmenfassung der Schicht bzw. Schichten in festem Abstand von der Rahmenfassung der Fasern verbleibt, so daß jede Faser auf der an der Rahmenfassung montierten einzigen Schicht oder der Mehrfachanordnung von Schichten eine vorgeschriebene Netzanordnung oder Schaltung druckt.

34. Verfahren nach Anspruch 33, dadurch gekennzeichnet, daß der Abstand zwischen den Rahmenfassungen für die Schicht und die Fasern derart justiert wird, daß der Abstand zwischen Faser und Schicht dem gewünschten Druck entspricht.

35. Verfahren nach Anspruch 33 oder 34, zur Verbindung von vorgeschriebenen Netzanordnungen oder Schaltungen von Kristalliten, die sich auf ein und derselben polymetallischen Schicht befinden, die aus zwei den Gruppen III bzw. V oder den Gruppen II bzw. VI des periodischen Systems angehörenden Elementen zusammengesetzt ist, dadurch gekennzeichnet, daß die die Schicht tragende Rahmenfassung derart verschoben wird, daß die Aufprallvorgänge des durch die Fasern kanalisierten Laserstrahls die gewünschten Halbleiterkontakte zwischen jeder Netzanordnung oder Schaltung und ihren unmittelbaren Nachbarn auf der Schicht drucken.

36. Verfahren zur Kristallisation zweier übereinanderliegende filmartige Schichten, die einerseits aus der die elementaren amorphen Halbleiterschichten enthaltenden Gruppe und andererseits aus der die aus zwei den Gruppen III bzw. V oder den Gruppen II bzw. VI des periodischen Systems angehörenden Elementen zusammengesetzten polymetallischen Schichten ausgewählt sind, dadurch gekennzeichnet, daß eine erste Schicht nach einem der Ansprüche 1 bis 32 kristallisiert wird, daß dieser Schicht durch Aufdampfen eine zweite Schicht überlagert wird und daß diese zweite Schicht auf dieselbe Art und Weise bestrahlt wird wie die erste, so daß sich eine epitaktische Kristallisation der zweiten Schicht auf der ersten ergibt.

37. Verfahren nach Anspruch 35, dadurch gekennzeichnet, daß die erste Schicht eine aus einer abwechselnden Folge von Aluminium- und Antimonschichten bestehende zusammengesetzte Schicht ist und daß die zweite Schicht aus Silizium gebildet wird.

## Claims

1. A method for crystallizing films selected from the group comprising the amorphous elementary semi-conducting films and the polymetallic films comprised of two elements belonging respectively to Groups III and V, or Groups II and VI of the Periodic Table, characterized in that it comprises irradiating the film surface with a laser beam guided by an assembly from optic fibers which are arranged in parallel relationship with one another, each fiber having a diameter which is not larger than 50 $\mu$m, to that said irradiating causes crystallizing into crystallites which are regularly distributed and closely confined.

2. A method as defined in claim 1, characterized in that said optic fibers have a diameter equal to 50 $\mu$m.

3. A method as defined in any of claims 1 and 2, characterized in that said film is deposited on a non-crystalline substrate.

4. A method as defined in claim 1, characterized in that said optic fibers have a diameter lying between 4 and 25 $\mu$m.

5. A method as defined in any of claims 1 to 4, characterized in that said optic fibers each have the same diameter.

6. A method as defined in any of claims 1 to 5, characterized in that use is made for said optic fibers, of identical quartz fibers.

7. A method as defined in any of claims 1 to 6, characterized in that the assembly of parallel optic fibers has a diameter which is substantially equal to the laser beam diameter.

8. A method as defined in claim 7, characterized in that the fiber assembly comprises from 300 to 15000 fibers.

9. A method as defined in any of claims 1 to 8, characterized in that said laser beam is so arranged facing the assembled optic fibers as to enter said fibers along the lengthwise axis thereof.

10. A method as defined in any of claims 1 to 9, characterized in that the optic fibers are compactly arranged, polished at each end thereof, and retained by the end thereof facing the beam by means of a metal ring with a diameter which is not larger than the useful laser beam diameter.

11. A method as defined in claim 10, characterized in that the respective ends of the assembled fibers lie in one and the same plane which is substantially at a right angle to the lengthwise axis of said fibers.

12. A method as defined in any of claims 1 to 11, characterized in that said laser beam is made homogeneous before being guided by the fiber assembly.

13. A method as defined in claim 12, characterized in that said laser beam is made homogeneous by passing through a cylinder-like quartz rod with an input diameter which is substantially equal to the laser beam diameter, bent twice at a right angle in opposite directions, coated with a metal layer, the input and output ends of the rod being polished, in parallel relationship with one another and at a right angle to the axis thereof.

14. A method as defined in claim 13, characterized in that said laser beam is focused by a lens system before being made homogeneous.

15. A method as defined in any of claims 1 to 14, characterized in that the radiation from the laser beam is reduced by one or a plurality of filters lying in the beam path each at a right angle thereto, before entering the optic fiber assembly.

16. A method as defined in any of claims 1 to 15, characterized in that the laser beam is structured after passing through said optic fiber assembly.

17. A method as defined in claim 16, characterized in that said laser beam is structured by passing through an optical means to generate interference fringes.

18. A method as defined in claim 17, characterized in that said optical means for generating interference fringes is comprised of an optic grating from etched quartz.

19. A method as defined in claim 17, characterized in that said optical means for generating interference fringes is comprised of a Fresnel's lens.

20. A method as defined in claim 17, characterized in that said optical means for generating interference fringes is comprised of a metal grid or screen with a regular and very fine mesh lying at a right angle to the fiber axis.

21. A method as defined in any of claims 1 to 20, characterized in that said non-crystalline substrate is cleaned by ion bombardment with a neutral gas such as argon.

22. A method as defined in any of claims 1 to 21, characterized in that the laser beam which irradiates said film is in pulsated mode with an energy between 50 and 100 mJ/cm².

23. A method as defined in any of claims 1 to 21, characterized in that the laser beam which irradiates said film is in continuous mode with an energy between 1 and 5 J/cm².

24. A method as defined in any of claims 1 to 22, characterized in that the film thickness is thinner than or equal to 0.2 $\mu$m and the laser beam is a dye pulsated laser beam.

25. A method as defined in any of claims 1 to 22, characterized in that the film thickness lies between 1 and 2 $\mu$m, and said laser beam is a ruby pulsated laser beam.

26. A method as defined in any of claims 1 to 21 and 23, characterized in that the film thickness lies between 2 and 25 $\mu$m, and the laser beam is a continuous gas laser beam.

27. A method as defined in any of claims 1 to 26, characterized in that the size and distribution of the crystallites on the film is controlled as a function of the optic fiber diameter, the fiber-film spacing, and the wave length, the energy and the power of said laser beam which irradiates said film.

28. A method as defined in claim 27, characterized in that the filter-film spacing lies in the range from 0,5 to 5 mm.

29. A method as defined in any of claims 1 to 28, characterized in that said film is moved in a plane at a right angle to the fibe axis in such a way as to obtain a regular crystallite network or circuit.

30. A method as defined in claim 29, characterized in that the print fineness of the crystallite network or circuit is controlled by the film movement speed and the recurrence rate of the laser pulses.

31. A method as defined in any of claims 1 to 30, characterized in that the film is made of an amorphous semi-conducting film formed by silicium or germanium.

32. A method as defined in any of claims 1 to 30, characterized in that the film is made of a polymetallic film comprised of alternating layers from aluminum and antimony, aluminum and arsenic, galium and arsenic, indium and phosphorus (Groups III and V), from cadmium and sulfur, or cadmium and tellurium (Groups II and VI).

33. A method for multiplying the print of a regular crystallite network or circuit on a single film or an assembly from films selected in that group which comprises the amorphous elementary semi-conducting films and the polymetallic films comprised of two elements respectively from Groups III and V, or Groups II and VI of the Periodic Table, characterized it that it comprises irradiating the surface of the semi-conducting film or films with a laser beam which is guided by an assembly of optic fibers as defined in any of claims 1 to 28, by assembling the fiber output ends mounted along the beam axis on a fixed plane-frame with a geometrical shape suitable for the number of fibers and the extension of the required printed network or circuit, the fibers on the frame lying in parallel relationship with one another and the ends thereof lying in one and the same plane in parallel relationship with the frame plane, and by arranging in parallel relationship with the fiber frame and facing same, a movable plane-frame on which is mounted said film covering the complete surface area of said frame, or said assembly of films which are distributed with a geometrical shape identical with the shape of the fiber mounting on said fiber frame, each fiber facing a given film, and moving that frame bearing the film or film assembly with a traversing movement relative to the fiber frame, the film frame remaining at a fixed spacing relative to the fiber frame, to thus let each fiber print a regular crystallite network or circuit over the single film or each film mounted on said frame.

34. A method as defined in claim 33, characterized in that said spacing between the film frame and fiber frame is so adjusted as to have the spacing between said fiber and film correspond to the required print.

35. A method as defined in any of claims 33 and 34 for making the interconnecting of regular crystallite networks or circuits obtained on a single polymetallic film comprised of two elements respectively from Groups III and V, or Groups II and VI of the Periodic Table, characterized in that it comprises moving said film frame in such a way as to cause the impacts from the channeled laser beam to print the required semi-conducting contacts between each network or circuit and the directly adjacent networks or circuits on said film.

36. A method for crystallizing two superimposed films selected on the one hand in that group comprising the amorphous elementary semi-conducting films and on the other hand, those polymetallic films comprised of two elements respectively from Groups III and V, or Groups II and VI of the Periodic Table, characterized in that it comprises crystallizing a first film by the method as defined in any of claims 1 to 32, superimposing by evaporating a second film thereon, and irradiating said second film in the same way as said first film to obtain an epitaxial crystallizing of said second film on said first film.

37. A method as defined in claim 36, characterized in that said first film is a film which is comprised of alternating layers from aluminum and antimony, and said second film is formed by silicium.